# EUROPEAN PATENT APPLICATION

(11) **EP 4 415 010 A1**
(43) Date of publication of application: **14.08.2024**
(21) Application number: 23305174.7
(22) Date of filing: 09.02.2023
(51) Int. Cl.: H01G 4/08, H01L 29/92, H10N 97/00

(54) **AN ELECTRICAL DEVICE COMPRISING A MONOLITHIC DIAMOND REGION COMPRISING A CAPACITOR**

(71) Applicant: Murata Manufacturing Co., Ltd., Nagaokakyo-shi, Kyoto 617-8555 (JP); Commissariat à l'énergie atomique et aux énergies alternatives, 75015 Paris (FR)
(72) Inventor: BUFFLE, Larry, 38000 GRENOBLE (FR); VOIRON, Frédéric, 38530 BARRAUX (FR); POMORSKI, Michal, 91191 Gif-sur-Yvette Cedex (FR); TRUFFET, Baptiste, 91191 Gif-sur-Yvette Cedex (FR)
(74) Representative: Cabinet Beau de Loménie

(57) **Abstract**

An electrical device comprising a capacitor comprising a monolithic diamond region comprising:
a diamond substrate (100),
a first electrode layer (110) on the diamond substrate,
an intermediate layer (115) on the first electrode layer having a dislocation density comprised between 10⁵.cm⁻² to 10⁹.cm⁻² , and
a second electrode layer (120) on the intermediate layer,
wherein the first electrode layer and the second electrode layer are doped with p-type impurities and the intermediate layer is doped with a deep level dopant of type n that passivates the dislocations of the intermediate layer,
such that the capacitor is formed by the monolithic diamond region between the stack formed by the first electrode layer and the second electrode layer separated by the intermediate layer.

## Description

### Field of the Invention

The present invention relates to the field of integration and, more particularly, to electronic products, related semiconductor products, and their methods of manufacture.

### Technical Background

In the emerging field of high-voltage capacitor applications (e.g., operating/breakdown voltages from around 500 V to greater than 1 kV), a main concern is preventing early fails and/or premature wear out of the capacitor device due to the high voltage operation. This concern means that the operating electric field must be guaranteed with a sufficient margin for the desired lifetime of the device.

One way to sustain the operating electrical field is by increasing the thickness of the dielectric layer (typically a silicon-based material) used in the capacitor. However, the increase of the dielectric thickness brings various challenges as discussed below.

In one aspect, it is known that to obtain optimal (e.g., intrinsic) dielectric properties, the dielectric layer should be deposited at high temperatures (e.g., above 600° Celsius). Generally, however, this results in an increase of mechanical stress in the structure when the wafer is then cooled down to ambient temperature. With the use of a thicker dielectric layer, this problem is exacerbated, leading to cracks and/or delamination being observed in the dielectric layer. These cracks and/or delamination not only introduce weak points in the dielectric layer but can also generate a great amount of particles that may contaminate clean-room deposition tools. In extreme cases, the mechanical stress in the structure can be so high as to cause severe deformation in the wafer to the point that the wafer can no longer be transported by automatic robotic handlers.

In another aspect, the increase of dielectric thickness increases electrical stress within the structure (particularly when the structure is made three-dimensional to increase capacitance density) which impacts the long-term robustness of the dielectric. Specifically, it is known that, in a 3D trench capacitor structure, the electrostatic field exhibits magnitude peaks at singular points (e.g., sharp corners) of the electrode geometry. The increase of the thickness of the dielectric causes even greater electrostatic field concentrations at the singular points, resulting in faster dielectric wear out and/or earlier breakdown.

The conventional solution of increasing the dielectric thickness, especially of a silicon-based dielectric material, has thus clear limitations and can be at odds with the objectives of increasing device reliability and capacitance density, particularly for high-voltage capacitor applications.

Diamond has been proposed as a suitable material for high voltage applications. Monocrystalline diamond has been observed to provide comparable performances in terms of breakdown field, leakage current, permittivity, with respect to conventional silicon-based dielectric layers. In particular, diamond has been observed to reach high breakdown voltages, which is particularly suitable for high voltage devices.

A particular drawback of diamond devices is the density of dislocations, leading to the presence of leakage currents. Epitaxial techniques that limit the presence of dislocations in diamond such as homoepitaxy or High-Pressure High Temperature (HPHT) techniques. However, these techniques are not suitable for industrialization and particularly for obtaining wafers compatible with semiconductor fabrication machines (for example, it is not possible to form 6inch wafers including a diamond surface using these techniques). Document "Diamond wafer technologies for semiconductor device applications" (Section 1.3, "Single crystal diamond wafers", Yoshiaki Mokuno et al., Power Electronics Device Applications of Diamond Semiconductors, 2018) discloses the limitations in terms of dislocation density of these techniques.

There remains a need for a solution that overcomes these defects.

### Summary of the Invention

The present invention provides an electrical device comprising a capacitor comprising a monolithic diamond region comprising:
a diamond substrate,
a first electrode layer on the diamond substrate,
an intermediate layer on the first electrode layer having a dislocation density comprised between 10⁵.cm⁻² to 10⁹.cm⁻² (or for example between 10⁷.cm⁻² to 10⁹.cm⁻²), and
a second electrode layer on the intermediate layer,
wherein the first electrode layer and the second electrode layer are doped with p-type impurities and the intermediate layer is doped with a deep level dopant of type n that passivates the dislocations of the intermediate layer,
such that the capacitor is formed by the monolithic diamond region between the stack formed by the first electrode layer and the second electrode layer separated by the intermediate layer.

As the device uses a monolithic diamond region, i.e. a continuously monocrystalline diamond region, three is no built-in stress and no thermomechanical stress within this region. It should be noted that in the present application, a monolithic diamond region is monolithic/monocrystalline to the extent of what a plurality of successive diamond epitaxy steps can produce (which also avoids any lattice damage when the intermediate layer and the electrode layers are grown). Also, in the present application, a monolithic diamond region can include dislocations, as indicated above for the intermediate layer. Also, in the present application, doping impurities are not considered to affect the monocrystalline nature of a region, thus, the different layers having different doping types and levels also form a monolithic/monocrystalline region.

Also, forming a monolithic diamond region prevents delamination or cracks from appearing, which is typically the case with thick (1 to 3 µm) dielectric regions in accordance with the prior art.

It has been observed that junctions, resulting from the difference in terms of doping are formed in the above structure at the level of the interfaces between the first electrode layer and the intermediate layer. Indeed, a structure having two back-to-back diodes (with anodes connected together) is obtained. It has also been observed that these junctions are particularly robust as their avalanche effect is reversible (with no damage introduced by going over the avalanche voltage of both junctions).

Furthermore, it has been observed that with appropriate thicknesses and doping levels, the device exhibits a constant capacitance against the applied voltage and against temperature: thus, a capacitor is formed by the first electrode layer and the second electrode layer separated by the intermediate layer. By "a capacitor is formed", what is meant is that the monolithic region behaves as a capacitor, at least in terms of having a constant capacitance against the voltage applied (but a capacitance that may vary in accordance with frequency).

This can be explained by the intermediate layer being fully depleted of carrier over a large distance that covers the entirety of the thickness of the intermediate layer (for example the intermediate layer has a carrier concentration of about 10¹⁴ to 10¹⁸ for the dopant that passivates the dislocations).

The device behaving as a capacitor results from the behavior of the Space Charge Region (SCR). Under reverse polarization carriers are following the electric field, thus minority carriers are pulled toward the electrode interface and majority carriers are pushed away out of the SCR. The SCR depth varies with the electrical field. When the voltage increases, the SCR sees an electrical field that will reach the breakdown field (EBD) of the material and consequently the avalanche. As diamond is used, the deep nitrogen-vacancy centers (the n doping at a level that brings n diamond near the intrinsic), are recombining with the minority free carriers thus leaving a charge free area over the depth of the intrinsic layer (i.e. the intermediate layer). It has been observed that the capacitance corresponds to the thickness of the intermediate layer, and does not vary with the applied voltage. Having dislocations in the intermediate layer with a dislocation density comprised between 10⁵.cm⁻² to 10⁹.cm⁻² can result from the use of heteroepitaxy in the manufacture of the substrate. Heteroepitaxy of diamond has shown to be implementable in the manufacture of wafers such as 6 inch wafers (or of other manufacturing techniques producing more dislocations than HPHT). Hence, the above device is suitable for industrialization. Other techniques may also be used, for example mosaic based techniques, with different dislocation densities.

It should be noted that the first electrode layer and the second electrode layer may also have the same dislocation density as the intermediate layer, as they are formed on the same diamond substrate.

The dislocation density can also be comprised between 10⁷.cm⁻² to 10⁹.cm⁻², so as to allow using techniques even more prone to dislocations.

It should be noted that the dislocation density, in the present application, applies to all possible directions in which the dislocations extend. The passivating effect is however more visible when the dislocations are orthogonal with the direction in which the layers extend, i.e. dislocations that are in the direction that goes from the first electrode layer to the second electrode layer.

The inventors of the present invention have observed that deep energy dopants, for example of type n and at low concentration, can passivate the dislocations by recombining free charges that might be emitted from the dislocations. It has been observed that this passivation limits the effect of leakage currents and allows manufacturing capacitors on substrates comprising heteroepitaxial diamond (i.e. the diamond substrate can comprise an upper surface of heteroepitaxial diamond and it may include a lower region of a material that differs from diamond - the lower region of a material that differs from diamond may also be removed, for example grinded away).

By passivating, what is meant is that the free carriers are recombining with deep trap centers (N) and do not have sufficient lifetime/free path to contribute to the leakage.

According to a particular embodiment, the intermediate layer has a thickness superior to 0.1 µm, or preferably superior to 0.5 µm, or preferably superior to 1 µm, or even preferably superior to 2 µm.

These thicknesses and especially the larger values have been observed to provide capacitors that can operate with higher voltage values.

According to a particular embodiment, the monolithic diamond region comprises a stacked structure including N successive electrode layers respectively separated by N-1 intermediate layers arranged between successive electrode layers, with N superior or equal to 3,
wherein the N electrode layers are doped with p-type impurities and N-1 intermediate layer is doped with a deep level dopant of type n that passivates the dislocations of the intermediate layer, such that the monolithic diamond region behaves as a capacitor between each successive electrode layer.

This structure forms a multilayer capacitor, which can be advantageous for specific applications.

The intermediate layers may all have a dislocation density comprised between 10⁵.cm⁻² to 10⁹.cm⁻².

According to a particular embodiment, a first group of the N successive electrode layers are connected together, and a second group of the N successive electrode layers are connected together, and wherein every two successive electrode layers in the stacked structure belong respectively to two different groups.

In this embodiment, a parallel capacitive structure is obtained, thereby increasing the capacitance of the entire structure.

According to a particular embodiment every electrode layer partially covers the below electrode layer in the stacked structure and wherein an electrical connection to the below electrode layer is arranged in the uncovered portion of this electrode layer.

For example, the structure may be pyramidal.

According to a particular embodiment, the electrical device is transparent to visible light through at least a portion of the stack formed by the electrode layers and the intermediate layer.

It has been observed that for some applications, it is preferable to have a device that does not mask what is below the device. The use of diamond provides a transparent structure, and, with electrical connections being provided for example on the sides of each layer, a middle portion can be obtained which is see-through.

The invention also provides a method of manufacturing a capacitor comprising:
obtaining a diamond substrate,
forming, by epitaxy of diamond, a first electrode layer on the diamond substrate,
forming, by epitaxy of diamond, an intermediate layer on the first electrode layer having a dislocation density comprised between 10⁵.cm⁻² to 10⁹.cm⁻² (or for example between 10⁷.cm⁻² to 10⁹.cm⁻²),
forming, by epitaxy of diamond, a second electrode layer on the intermediate layer,
wherein the first electrode layer and the second electrode layer are doped with p-type impurities and the intermediate layer is doped with a deep level dopant of type n, the deep level dopant of type n passivating the dislocations of the intermediate layer, such that the capacitor is formed by the monolithic diamond region between the stack formed by the first electrode layer and the second electrode layer separated by the intermediate layer.

This method can be adapted for the manufacture of any one of the above defined devices.

According to a particular embodiment, during the epitaxy of the first electrode layer and during the epitaxy of the second electrode layer, impurities are introduced.

According to a particular embodiment, the method comprises, in a preliminary step, forming the diamond substrate by heteroepitaxy of diamond on a material that differs from diamond.

The invention also provides a method of using an electrical device as defined above (in any one of the above-defined embodiments), wherein a voltage applied to the capacitor exceeds 700 V, or preferably 900 V, or even more preferably 1.2 kV.

According to a particular embodiment, the capacitor presents an avalanche voltage above 700 V, the method comprising, after applying a voltage exceeding 700V, applying a voltage lower than 700V.

### Brief Description of the Drawings

Further features and advantages of the present invention will become apparent from the following description of certain embodiments thereof, given by way of illustration only, not limitation, with reference to the accompanying drawings in which:
- Figure 1 is a side-view of a device according to an example;
- Figures 2A and 2B are graphs illustrating the electrical properties of a device with no passivation of dislocations;
- Figures 3A and 3B are graphs illustrating the electrical properties of a device according to an example.

### Detailed Description of Example Embodiments

We will now describe electrical devices comprising a monolithic diamond region that behaves, between two electrodes, as a capacitor, such that a capacitor is formed. The capacitors described herein are particularly suitable for operating under high voltages (for example above 700 V, or preferably above 900 V, or even more preferably above 1.2 kV).

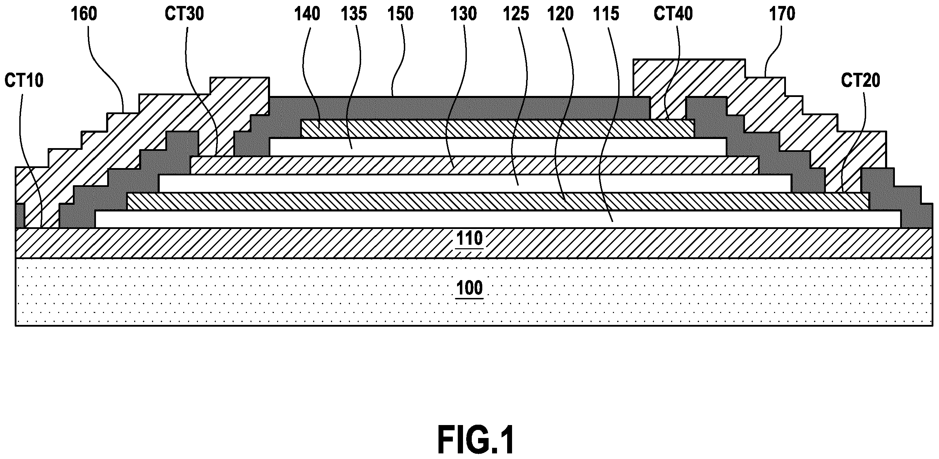

In reference to figure 1, we will now describe an exemplary structure including one such capacitor.

The structure will be formed above a substrate 100 which can be a monocrystalline diamond substrate or a monocrystalline diamond layer grown on a crystalline substrate, with a buffer layer in between (in this case, the top portion of the substrate on the figure is monocrystalline). Here, the substrate 100 is formed by heteroepitaxy of diamond on a material that differs from diamond.

On this substrate 100, a first electrode layer 110 is formed by a diamond epitaxy. This substrate is being referred to as an electrode as it is doped with p-type impurities. For example, boron can be introduced during the diamond epitaxy. It should be noted that the dopant can be introduced at the same time as the precursor for growing the diamond. The diamond lattice being particularly compact, it is too difficult to activate interstitial dopants to become substitutional as a temperature above 2000 °C may be required. Thus, introduction of dopants along with the precursor allows substitution to occur at the same time as the diamond lattice is formed.

The thickness of the first electrode layer can be above 100 nanometers, with a dopant concentration above 1.10¹⁸/cm³.

It should be noted that preferably, the substrate 100 (or at least the monocrystalline diamond portion) should have the opposite doping type. Also, the substrate 100 can be patterned in a preliminary step, this patterning can be performed by means of selective diamond epitaxy in a hard mask or by a photolithography step using a photosensitive mask, a dry etching step (for example using a mixture of argon and dioxygen), and a subsequent surface cleaning step (for example using a hot acid, for example sulfuric acid (H₂SO₄)). As shown on the figure, the first electrode layer 110 can match the patterning of the substrate 100.

On the first electrode layer 110, a first intermediate layer 115 has been formed by diamond epitaxy. The intermediate layer has a dislocation density comprised between 10⁵.cm⁻² to 10⁹.cm⁻², and it is doped with a deep level dopant of type n that passivates the dislocations of the intermediate layer..

By way of example, the deep level dopant of type n that passivates the dislocations of the intermediate layer can have a concentration comprised between 1.10¹⁴/cm3 (atomic) and 1.10¹⁹/cm³(atomic)

The deep level dopant of type n can be nitrogen.

The intermediate layer has a thickness superior to 0.1 µm, or preferably superior to 0.5 µm, or preferably superior to 1 µm, or even preferably superior to 2 µm.

It should be noted that the epitaxial steps mentioned herein can be Chemical Vapor Deposition (CVD) homoepitaxy that thickens a monocrystalline diamond region and preserves the monocrystalline nature of the material. However, dislocations are present in the electrode layers and the intermediate layer as the substrate was obtained by heteroepitaxy.

After forming the first intermediate layer, a P⁺-I(N) junction is obtained (p-type diamond and n-type diamond, i.e. a first diode is formed.

Above and on the first intermediate layer, a second electrode layer 120 is formed by a diamond epitaxy. This substrate is being referred to as an electrode as it is doped with p-type impurities. For example, boron can be introduced during the diamond epitaxy in a manner which is similar to what has been performed for the first electrode layer 110.

At this stage, two back-to-back diodes are formed in a unique diamond monocrystalline region, which implies that the internal mechanical stress is minimized.

As the intermediate layer is depleted of carriers, this intermediate layer acts as a dielectric in between the first and the second electrode layers 110 and 120.

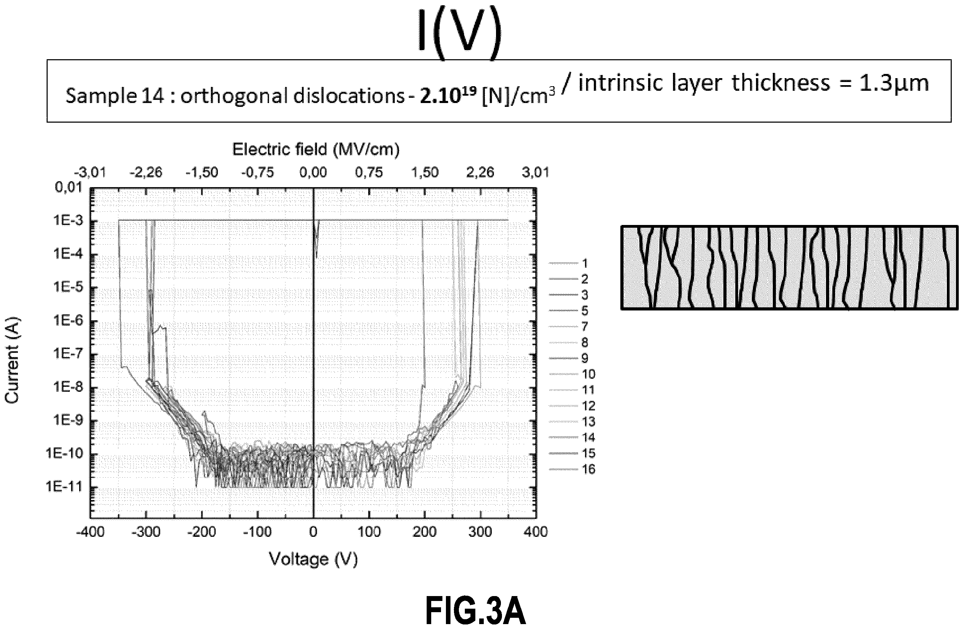

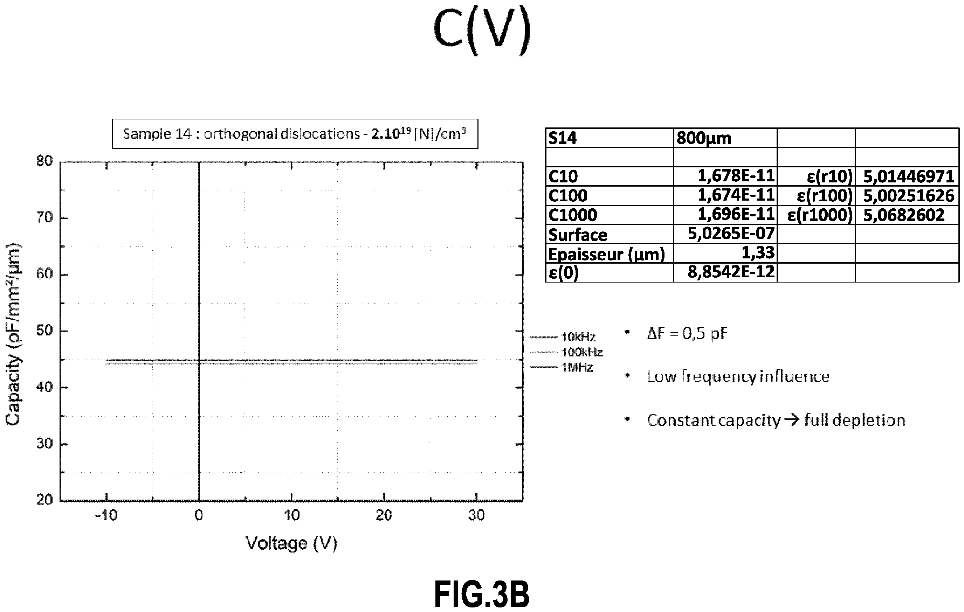

As will be explained in relation to figures 3A and 3B, the device obtained at this stage behaves as a capacitor.

While the device shown on figure 1 contains more than two electrode layers, the invention also concerns devices comprising only two electrodes. Devices with more than two electrodes are advantageous as they allow increasing the capacitance, without inducing additional mechanical stress. Here, a second intermediate layer 125 has been formed on the second electrode layer 120 (this intermediate layer is analogous to the intermediate layer 115, for example in terms of composition, deposition method, and thickness). A third electrode layer 130 has been formed on this second intermediate layer (this third electrode layer is analogous to the first and second electrode layers 110 and 120, for example in terms of composition, deposition method, and thickness). A third intermediate layer 135 has been formed on the third electrode layer 130 (this intermediate layer is analogous to the intermediate layer 115, for example in terms of composition, deposition method, and thickness). Finally, a fourth electrode layer 140 has been formed on this third intermediate layer 135 (this fourth electrode layer is analogous to the first, second, and third electrode layers 110, 120, and 130, for example in terms of composition, deposition method, and thickness).

A passivation layer 150 is formed above the obtained structure.

At this stage, three capacitors in series are formed by the monolithic diamond region between the first electrode 110 and the fourth electrode 140. In order to obtain parallelized capacitor and an increase of capacitance, the electrodes are connected together. To this end, each electrode only covers a portion of the electrode that is directly below this electrode, so that an electrical connection (i.e. a connection pad) can be arranged in the uncovered portion of the electrode below (the intermediate layers also only cover a portion of the electrode on which they are formed to leave the uncovered portion uncovered).

Here, the first and third electrode layers are connected together through openings CT10 and CT30 formed in the passivation layer and by deposition of a conductive region 160. Also, the second and fourth electrode layers are connected together through openings CT20 and CT40 formed in the passivation layer and by deposition of a conductive region 170.

It appears that a structure of three capacitors connected in parallel are formed.

More than four electrode layers can be formed. For example, any number of N successive electrode layers (by successive, what is meant is that they are formed by successive diamond epitaxy steps) can be formed separated by N-1 intermediate layers, with N being superior or equal to 3, with the electrode layers being analogous to the electrode layers 110, 120, 130, and 140, and the intermediate layers being analogous to the intermediate layers 115, 125, and 135.

Patterning the electrode layers can be performed using a dry etching using argon and oxygen, using methods that are known in themselves.

The structure may be pyramidal, so as to leave uncovered portions of electrode layers, as shown on figure 1.

It should be noted that the monolithic diamond region that has been formed can be transparent to visible light, which can be advantageous for given applications.

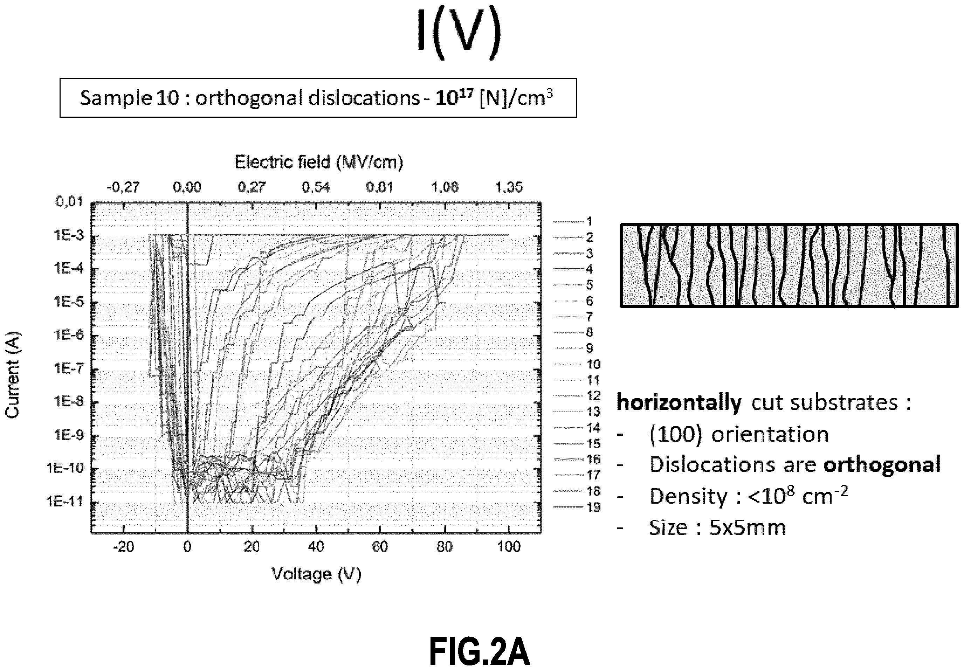

Figure 2A shows the evolution of the current in accordance with the voltage bias, for a plurality of different measurements made on a same device. The device used in this structure has been obtained by cutting a crystal of heteroepitaxial diamond to obtain a substrate (such as substrate 100) having dislocations substantially oriented in an orthogonal direction with respect to the top surface of the substrate. The subsequently formed electrode layers and intermediate layer will therefore have a dislocation density comprised between 10⁵.cm⁻² to 10⁹.cm⁻². The device has dimensions of about 5 millimeter by 5 millimeter.

Also, the device used to obtain the graph has an intrinsic intermediate layer, with a dopant concentration of about 1.10¹⁷/cm³. It can be observed on the figure that the electrical behavior of the device is unpredictable as the dislocations induce leakage currents through the device. In particular, there is a lot of leakage induced by the high amount of dislocations. The conductivity of each electrode appears to be homogeneous. It appears that a sweeping up to 60V is reversible and it is only above this value that electrical breakdown occurs and the electrode becomes fully conductive.

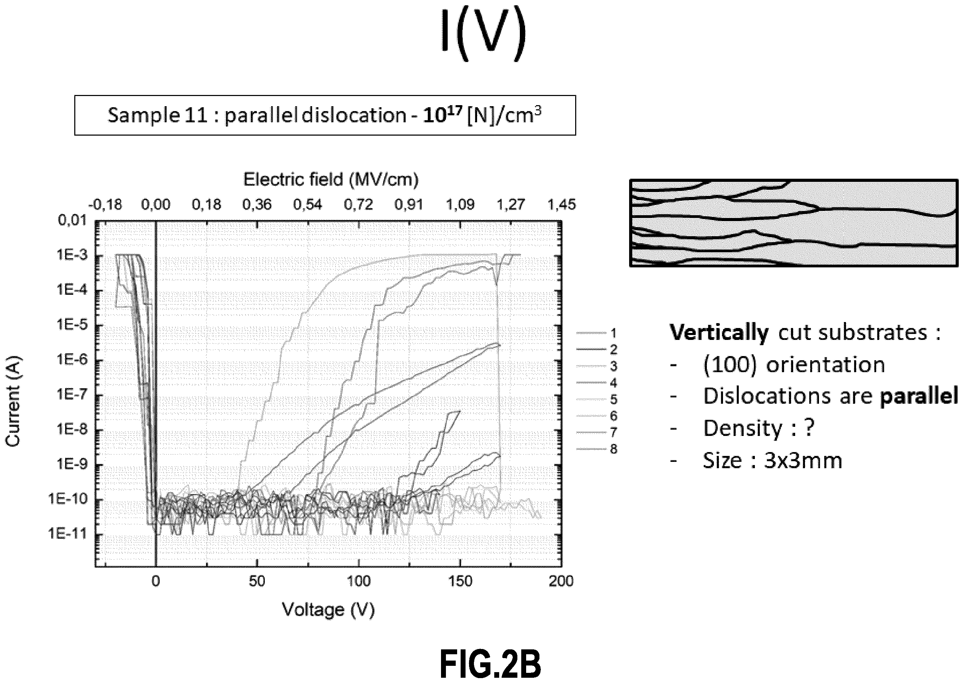

Figure 2B shows another device having an intrinsic intermediate layer, with a dopant concentration of about 1.10¹⁷/cm³. The device has been cut such that the dislocations are substantially oriented in a direction parallel to the top surface of the substrate. The device has dimensions of about 3 millimeter by 3 millimeter. The device exhibits more uniform behaviour than the device of figure 2A. Here, the leakage is inhomogeneous for each electrode. This may result from the change in dislocation density depending on where the electrodes are positioned onto the substrate.

Figure 3A shows the evolution of the current in accordance with the voltage bias, by sweeping the voltage bias back and forth. The device used to obtain this graph has an intermediate layer with orthogonal dislocations, but with deep level dopants of type n passivating the dislocations of the intermediate layer. Here, the deep level dopants of type n have a concentration of 2.10¹⁹/cm³.

The graph of figure 3A shows the behavior of the structure between two electrode layers, with a diode-like behavior under both polarities (the graph is substantially symmetric) with avalanche breakdowns effects being observable. This behavior shows a behavior that is similar to the one of a capacitive device including a dielectric. As a sweeping has been performed, it appears that a large reverse ionization current can be tolerated by the structure. This results from the avalanche effect of the two junctions, which is reversible for the diamond diodes formed within the monolithic diamond region.

Figure 3B is a graph showing the evolution of the capacitance of the device with respect to the voltage bias: it appears that the capacitance is nearly constant and barely varies in accordance with the frequency, in a manner which is similar to a capacitor including a dielectric.

The device of figures 3A and 3B is however more advantageous as it can withstand high voltages without being damaged (it is reversible). In particular, the device can be used with a voltage applied that exceeds 700 V, or preferably 900 V, or even more preferably 1.2 kV.

Also, the device of figure 3A and 3B is manufactured using a substrate obtained by heteroepitaxy of diamond, a solution suitable for industrialization.

### Additional Variants

Although the present invention has been described above with reference to certain specific embodiments, it will be understood that the invention is not limited by the particularities of the specific embodiments. Numerous variations, modifications and developments may be made in the above-described embodiments within the scope of the appended claims.

## Claims

1. An electrical device comprising a capacitor comprising a monolithic diamond region comprising:
a diamond substrate (100),
a first electrode layer (110) on the diamond substrate,
an intermediate layer (115) on the first electrode layer having a dislocation density comprised between 10⁵.cm⁻² to 10⁹.cm⁻², and
a second electrode layer (120) on the intermediate layer,
wherein the first electrode layer and the second electrode layer are doped with p-type impurities and the intermediate layer is doped with a deep level dopant of type n that passivates the dislocations of the intermediate layer,
such that the capacitor is formed by the monolithic diamond region between the stack formed by the first electrode layer and the second electrode layer separated by the intermediate layer.

2. The electrical device of claim 1, wherein the intermediate layer has a thickness superior to 0.1 µm, or preferably superior to 0.5 µm, or preferably superior to 1 µm, or even preferably superior to 2 µm.

3. The electrical device of any one of claims 1 or 2, wherein the monolithic diamond region comprises a stacked structure including N successive electrode layers (110, 120, 130, 140) respectively separated by N-1 intermediate layers (115, 125, 135) arranged between successive electrode layers, with N superior or equal to 3,
wherein the N electrode layers are doped with p-type impurities and N-1 intermediate layer is doped with a deep level dopant of type n that passivates the dislocations of the intermediate layer, such that the monolithic diamond region behaves as a capacitor between each successive electrode layer.

4. The electrical device of claim 3, wherein a first group of N successive electrode layers are connected together, and a second group of N successive electrode layers are connected together, and wherein every two successive electrodes in the stacked structure belong respectively to two different groups.

5. The electrical device of claim 4, wherein every electrode layer partially covers the below electrode layer in the stacked structure and wherein an electrical connection to the below electrode layer is arranged in the uncovered portion of this electrode (CT10, CT20, CT30, CT40).

6. The electrical device of any one of claims 1 to 5, wherein the electrical device is transparent to visible light through at least a portion of the stack formed by the electrode layers and the intermediate layer.

7. A method of manufacturing a capacitor comprising:
obtaining a diamond substrate,
forming, by epitaxy of diamond, a first electrode layer (110) on the diamond substrate,
forming, by epitaxy of diamond, an intermediate layer (115) on the first electrode layer having a dislocation density comprised between 10⁵.cm⁻² to 10⁹.cm⁻²,
forming, by epitaxy of diamond, a second electrode layer (120) on the intermediate layer,
wherein the first electrode layer and the second electrode layer are doped with p-type impurities and the intermediate layer is doped with a deep level dopant of type n, the deep level dopant of type n passivating the dislocations of the intermediate layer, such that the capacitor is formed by the monolithic diamond region between the stack formed by the first electrode layer and the second electrode layer separated by the intermediate layer.

8. The method of claim 7, wherein during the epitaxy of the first electrode layer and during the epitaxy of the second electrode layer, impurities are introduced.

9. The method of claim 7, comprising, in a preliminary step, forming the diamond substrate by heteroepitaxy of diamond on a material that differs from diamond.

10. A method of using an electrical device in accordance with any one of claims 1 to 6, wherein a voltage applied to the capacitor exceeds 700 V, or preferably 900 V, or even more preferably 1.2 kV.

11. The method of claim 10, wherein the capacitor presents an avalanche voltage above 700 V, the method comprising, after applying a voltage exceeding 700V, applying a voltage lower than 700V.
